# EUROPÄISCHE PATENTSCHRIFT

(11) **EP 3 557 352 B1**
(45) Veröffentlichungstag und Bekanntmachung des Hinweises auf die Patenterteilung: **02.12.2020**
(21) Anmeldenummer: 18168446.5
(22) Anmeldetag: 20.04.2018
(51) Int. Cl.: G05B 19/418

(54) **VERFAHREN UND COMPUTERGESTÜTZTES SYSTEM ZUR ERFASSUNG VON LEBENSZYKLUSINFORMATIONEN ÜBER EINEN SCHALTSCHRANK EINER INDUSTRIELLEN ANLAGE**
METHOD AND COMPUTERIZED SYSTEM FOR DETECTING OF LIFE CYCLE INFORMATION VIA AN ELECTRICAL ENCLOSURE OF AN INDUSTRIAL INSTALLATION
PROCÉDÉ ET SYSTÈME ASSISTÉ PAR ORDINATEUR PERMETTANT DE DÉTECTER DES INFORMATIONS DE CYCLE DE VIE AU MOYEN D'UNE ARMOIRE DE DISTRIBUTION D'UNE INSTALLATION INDUSTRIELLE

(43) Veröffentlichungstag der Anmeldung: 23.10.2019
(73) Patentinhaber: Rittal GmbH & Co. KG, 35745 Herborn (DE)
(72) Erfinder: WEICHSEL, Thomas, 41812 Erkelenz (DE); MICHELS, Thomas, 53842 Troisdorf (DE); MARTIN, Lars, 35516 Münzenberg (DE); ZACHRAI, Judith, 35745 Herborn (DE)
(74) Vertreter: Kietzmann, Lutz

(56) Entgegenhaltungen:
- EP-A1- 3 229 175
- EP-A2- 0 637 029
- WO-A1-2010/054143
- WO-A1-2011/154212
- DE-A1-102013 102 635
- Birgit Adam: "Inbetriebnahmeprotokoll", Für Fachkräfte der Elektrotechnik und Elektrosicherheit, 14. Februar 2018 (2018-02-14), Seiten 1-3, XP055521389, Gefunden im Internet: URL:https://www.elektrofachkraft.de/pruefu ng/inbetriebnahmeprotokoll [gefunden am 2018-11-06]

## Beschreibung

Die Erfindung betrifft ein Verfahren sowie ein computergestütztes System zur Erfassung sowie zur Aufbereitung von Lebenszyklusinformationen über einen elektrischen Schaltschrank einer industriellen Anlage. Ferner umfasst die Erfindung auch ein das computergestützte Verfahren durchführendes Computerprogrammprodukt sowie ein spezielles Datenformat, welches schaltschrankspezifische Lebenszyklusinformationen enthält.

Das Einsatzgebiet der Erfindung erstreckt sich vornehmlich auf den Schaltschrankbau für industrielle Anlagen. Daneben kommen Schaltschränke der hier interessierenden Art vereinzelt auch im häuslichen Bereich zur Anwendung. Prinzipiell werden Schaltschränke zur geschützten Unterbringung von elektrischen und/oder elektronischen Komponenten genutzt, welche gewöhnlich in Form normierter Einbaumodule ausgebildet sind. Hiermit können beispielsweise automatisierte Fertigungsanlagen, verfahrenstechnische Anlagen, Werkzeugmaschinen oder dergleichen angesteuert werden. Somit handelt es sich bei den im Schaltschrank untergebrachten Einbaumodulen um steuerungstechnische Komponenten, die nicht direkt in der Maschine als Feldgerät platziert sind. Als Einbaumodule kommen beispielsweise speicherprogrammierbare Steuerungen, komplette Rechnereinheiten, Frequenzumrichter für Drehzahlsteuerungen von Motoren, Kommunikationsmodule für Busanbindungen zu unterschiedlichen Bussystemen, digitale Eingangs-/Ausgangs-Module oder auch analoge Eingangsmodule zum Einlesen von Sensordaten zum Einsatz. Daneben enthält ein Schaltschrank üblicherweise auch elektrische Klemmleisten zum Anschluss der elektrischen Verkabelung am Einsatzort, womit die Verbindung zur Stromversorgung und den anzusteuernden Maschinen und Anlagen hergestellt wird.

Die Planung von anwendungsbezogenen Schaltschrankausstattungen erfolgt üblicherweise softwaregestützt, beispielsweise über EPLAN Pro Panel®, in Form einer CAD-Konstruktion. Eine solche geplante Konstruktion umfasst insbesondere einen dreidimensionalen Montageaufbau in Form eines Layouts, eine virtuellen Verdrahtung der elektrischen und elektronischen Einbaumodule und gegebenenfalls anderer Komponenten sowie hierauf abgestimmte Stromverteilersysteme. Die elektrischen oder elektronischen Einbaumodule können beispielsweise mittels Hutschienen im Innenraum des Schaltschranks befestigt werden. Daneben umfasst die geplante Konstruktion auch Datenblattinformationen A der verbauten Einbaumodule. Derartige Datenblattinformationen können beispielsweise die elektrische Leistungsaufnahme, der Schutzgrad, die Ein-/Ausgangsanschlusskonfiguration, die Rechenleistung, der Hersteller und/oder das Herstellungsdatum, die Seriennummer und dergleichen sein. Derartige Datenblattinformationen sind vom Typ des Einbaumoduls abhängig.

Je nach Schaltschrankausstattung und Einsatzzweck des Schaltschranks sind Test- und Abnahmemaßnahmen vorzunehmen, ehe eine betriebssichere Inbetriebnahme des Schaltschranks am Einsatzort erfolgen kann. Dabei sind die aus der Testphase resultierenden Test- und Abnahmeinformationen zu dokumentieren, um eine planungskonforme und vorschriftsgemäße Herstellung nachweisen zu können.

Gemäß dem allgemein bekannten Stand der Technik erfolgt dies im Bereich des Schaltschrankbaus bislang durch vorkonfektionierte Schaltschrankmappen in Heftform, welche alle relevanten Formularfelder für erforderliche Eintragungen, umfassend eine Benennung der verbauten Einbaumodule und deren Test- und Abnahmeinformationen beinhalten. Tiefergehende technische Informationen über die Einbaumodule, beispielsweise Datenblattinformationen, sind nicht Bestandteil der Schaltschrankmappe. Diese sind jedoch in der Regel Bestandteil der Dokumentation der gesamten elektronischen Anlage, welche weiterhin die Schaltpläne, Klemmenpläne, Stücklisten und Gerätelisten umfasst. Daher ist ein Monteur in einem nachfolgenden Wartungs- oder Reparaturfall gewöhnlich darauf angewiesen, sich derartige ergänzende technische Informationen zusätzlich zu den in der Schaltschrankmappe enthaltenen Grundinformationen zu beschaffen, so dass unter Umständen eine Entscheidung über Reparaturmöglichkeiten eines defekten Schaltschranks in diesem Fall erst zu einem späteren Zeitpunkt getroffen werden können.

Aus der DE 101 16 539 B4 geht ein abstrakt allgemein gültiges computergestütztes Verfahren und System zur automatischen Datenaufbereitung im Umfeld Produktion, Montage, Service oder Wartung von Einrichtungen der Automatisierungstechnik hervor. Mit speziellen technischen Mitteln der sogenannten Augmented Reality (erweiterte Realität) werden dem Monteur durch entsprechende Mensch-Technik-Interaktion Informationen in sein Sichtfeld eingeblendet, wenn dieser ein Bauteil betrachtet. Dies können beispielsweise Montagehinweise sein, welche ein herkömmliches Montagehandbuch ersetzen. Die hier vorgestellte technische Lösung bezieht sich explizit auf den Einsatz von Augmented Reality in der Montage sowie im Bereich des Service und der Wartung.

Dem liegt die Problematik zugrunde, dass ein Fachmann in den Phasen des Lebenszyklus eines Produkts, wie beispielsweise dessen Erstellung, Inbetriebsetzung, Wartung und Entsorgung, eine Unterstützung durch umfangreiche Dokumentationen benötigt, welche als Handbücher, Montage- und Wartungsanleitungen, technische Zeichnungen und dergleichen üblicherweise in Papierform vorliegen. Vermehrt wird diese Dokumentation jedoch auch elektronisch angeboten und per Dokumentationsserver zentral verwaltet. Ein Zugriff auf diese Dokumentation kann über dezentral bedienbare Geräte, beispielsweise einen am Körper getragenen Computer mit Datenbrille oder dergleichen, erfolgen. Im Zusammenhang hiermit sind auch Mittel zur Erfassung von Anweisungen von Anwendern vorgesehen und es fließen Informationen über Fähigkeiten der dezentralen Bediengeräte sowie über Präferenzen der Anwender mit in die Datenverarbeitung ein, wobei die Visualisierung von Dokumentationsdaten und die Erfassung der Anweisungen jeweils in Abhängigkeit der von der Datenbank verwalteten Daten anpassbar sind. Dies eröffnet eine Vielfalt an Konnektivität. Allerdings ist das vorgestellte Verfahren und System des Standes der Technik lediglich auf eine Datenvisualisierung beschränkt.

Die WO 2011/154212 A1 offenbart ein computergestütztes Verfahren zur Erfassung und Aufbereitung von Lebenszyklusinformationen über Feldgeräte und deren Komponenten in einer industriellen Anlage, allerdings ohne einen konkreten Schaltschrankbezug, sondern in der Struktur eines verteilten Systems. Dabei werden im Zuge der Planung und Produktionsfertigstellung eines Feldgeräts ausgehend von der geplanten Konstruktion zumindest Datenblattinformationen über die Komponenten des Feldgeräts mit Funktionsinformationen über deren Anwendung in der industriellen Anlage verknüpft, um diese in einer zentralen Archivdatenbank eines Web Servers unter einer individuellen Kennung in Form von UUIDs zu hinterlegen. Dem können auch Test- und Abnahmeinformationen sowie per Konfigurier-/Parametriertool einprogrammierte Inbetriebnahmeinformationen hinzugefügt werden.

Die WO 2010/054143 A1 offenbart eine Schaltanlage, die mit einer On-Board-Dokumentation versehen ist. Die Schaltanlage ist zur Verteilung elektrischer Energie auf mehrere einzelne Lasten ausgelegt. Ein Industriecomputer verfügt über Speicher und drahtlose Übertragungsmittel sowie eine Reihe von Datenaustauschdiensten. Der Speicher speichert schaltgerätespezifische Dokumentation. Ein mobiles Computergerät dient zur Kommunikation mit dem Industriecomputer über das drahtlose Übertragungsmittel. Das mobile Computergerät enthält einen Webbrowser. Die Dokumentation wird dem mobilen Computer hierüber bereitgestellt.

Es ist die Aufgabe der vorliegenden Erfindung, ein spezielles computergestütztes Verfahren und System zur Erfassung und Aufbereitung von Lebenszyklusinformationen im Bereich der Schaltschranktechnik zu schaffen, mit welchem neben einer Visualisierung aktueller Dokumentationsinformationen über einen Schaltschrank auch eine Lebenszyklussteuerung ermöglicht wird.

Die Aufgabe wird verfahrenstechnisch gelöst, indem bei der Erstellung des Schaltschranks ausgehend von der geplanten Konstruktion zumindest Datenblattinformationen A der verbauten Einbaumodule mit Funktionsinformationen B über deren Anwendung in der industriellen Anlage verknüpft werden, um diese in einer zentralen Archivdatenbank unter einer individuellen Schaltschrankkennung in Datensätzen zu hinterlegen, wobei bei einer technischen Abnahme des Schaltschranks zu den Datensätzen Test- und Abnahmeinformationen C des Schaltschranks unter Berücksichtigung zumindest der Datenblattinformationen A hinzugefügt werden, bei der Inbetriebnahme des Schaltschranks den Datensätzen der Archivdatenbank ergänzende Inbetriebnahmeinformationen D des Schaltschranks über ein dezentral bedienbares Nutzerterminal hinzugefügt werden, wobei das Auslösen der Inbetriebnahmefreigabe für den Schaltschrankdurch einen auf die Archivdatenbank zugreifenden Dokumentationsserver über das dezentrale Nutzerterminal dann durchgeführt wird, wenn die hierfür durch den Benutzer zuvor erfassten notwendigen Test- und Abnahmeinformationen - welche sich aus den abgespeicherten Datenblattinformationen A der verbauten Einbaumodule ergeben - in der Archivdatenbank hinzugefügt wurden.

Das Auslösen der Inbetriebnahmefreigabe beinhaltet mindestens eine Verbindung von einer Energiequelle zu dem Schaltschrank und/oder mindestens eine Verbindung vom Schaltschrank zu der industriellen Anlage, um diese zu aktivieren. Erfolgt nach erteilter Inbetriebnahmefreigabe diese Inbetriebnahme des Schaltschranks am Einsatzort, so werden die Datensätze der Archivdatenbank um ergänzende Inbetriebnahmeinformationen D des Schaltschranks weiter angereichert, welche über das dezentral bedienbare Nutzerterminal vorzugsweise vom Einsatzort des Schaltschranks aus der zentralen Archivdatenbank hinzugefügt werden.

Der Vorteil der erfindungsgemäßen Lösung liegt insbesondere darin, dass bereits zum Zeitpunkt der Erstellung des Schaltschranks eine Dokumentation aufgebaut wird, welche eine höhere Informationstiefe als eine ansonsten übliche Schaltschrankmappe in Papierform bietet, indem nicht nur die verbauten Einbaumodule benannt und gekennzeichnet sind, sondern auch deren Datenblattinformationen A mit in die Dokumentation implementiert - in einfachster Weise verlinkt - sind. Darüber hinaus liefern hiermit verknüpfte Funktionsinformationen B Angaben darüber, welche Funktion ein bestimmtes Einbaumodul im Rahmen der Schaltschrankausstattung zu erfüllen hat, beispielsweise die Ansteuerung eines Frequenzeinrichters für einen Drehstrommotor einer Pumpe oder dergleichen.

Dank der erfindungsgemäßen Lösung wird es ermöglicht, notwendige Informationen über den gesamten Produktlebenszyklus des Schaltschranks mitzuführen und diese dynamisch zu aktualisieren. Dabei können Übergänge zwischen verschiedenen Stadien eines Lebenszyklus gesteuert werden, um Fehler bei der Inbetriebnahme oder dem späteren Betrieb des Schaltschranks zu vermeiden.

Gemäß einer weiteren die Erfindung verbessernden Maßnahme wird vorgeschlagen, dass zum Zeitpunkt durchzuführender Wartungen oder Reparaturen nach Inbetriebnahme des Schaltschranks diesbezügliche Wartungsinformationen E bzw. Reparaturinformationen F der Archivdatenbank über ein dezentral bedienbares Nutzerterminal hinzugefügt werden können, um die Informationen über die aktuelle Schaltschrankausstattung zu aktualisieren. Diese Aktualisierung umfasst beispielsweise Austauschinformationen über defekte Einbaumodule, eine Erweiterung der Schaltschrankausstattung um weitere Einbaumodule, beispielsweise einer Fernüberwachungseinheit oder dergleichen.

Über das dezentral bedienbare Nutzerterminal lässt sich in vorteilhafter Weise gemäß einem anderen optionalen Aspekt der Erfindung auf die zur Durchführung einer Reparatur erforderliche dreidimensionale geplanten Konstruktion zugreifen, um über hieraus hervorgehende ergänzende Konstruktionsinformationen H beispielsweise eine Entscheidung dahingehend treffen zu können, ob eine erforderliche Reparatur vor Ort durchgeführt werden kann, oder ob eine Überführung des defekten Schaltschranks in eine ortsferne Werkstatt notwendig ist. Dasselbe gilt analog auch für einen geplanten weiteren Ausbau einer Schaltschrankausstattung.

Prinzipiell kann eine Änderung von auf den Schaltschrank bezogenen Datensätzen in der Archivdatenbank durch den Nutzer oder auch den Schaltschrankhersteller selbst vorgenommen werden. Hierdurch besteht die Möglichkeit, dass der Nutzer selbst Änderungen an der Schaltschrankausstattung vornehmen kann, welche in der Dokumentation der Archivdatenbank nachgehalten wird. Darüber hinaus besteht auch die Möglichkeit, dass diese Dokumentationsaktualisierungsmaßnahme auch vom Schaltschrankhersteller durchgeführt wird, was insbesondere bei größeren Änderungen in der Schaltschrankausstattung vorteilhaft ist, um die Datenkonsistenz sicherzustellen. Somit stellt die erfindungsgemäße Lösung eine dynamische Dokumentation mit Zugriff von verschiedenen Benutzerebenen her bereit. Dies schafft beispielsweise auch die Voraussetzung dafür, dass nach einer Änderung einer Schaltschrankausstattung der normgerechte Umbau auch von externer Stelle her zertifizierbar ist, beispielsweise in Form einer Zertifizierung nach Norm (DIN / EN / ISO / NEC / UL / CSA).

Gemäß einer weiteren die Erfindung verbessernden Maßnahme wird vorgeschlagen, dass zum Zeitpunkt auftretender Störungen des Betriebs des Schaltschranks diesbezügliche Störungsinformationen G des Schaltschranks der Archivdatenbank automatisch oder über ein dezentral bedienbares Nutzerterminal hinzugefügt werden. Findet beispielsweise ein Stromausfall statt, welches den Betrieb des Schaltschranks sowie der hieran angeschlossenen industriellen Anlage unterbricht, so wird dieses Störungsereignis zur lückenlosen Erfassung von Lebenszyklusinformationen der Archivdatenbank hinzugefügt. Eine Störungsinformation G kann beispielsweise auch der Ausfall eines Einbaumoduls oder das Überschreiten einer zulässigen Betriebstemperatur sein. Aus derartigen Störungsinformationen G können beispielsweise Wartungsintervalle angepasst werden.

Vorzugsweise sollten die über das dezentral bedienbare Nutzerterminal zugänglichen Lebenszyklusinformationen des Schaltschranks erst nach autorisierter Eingabe der Schaltschrankkennung mit Passwortschutz zur Visualisierung und Anpassung der in der Archivdatenbank hinterlegten Informationen A bis G abgerufen werden können. Indem die Historie vormals eingegebener Informationen in der Archivdatenbank unveränderbar hinterlegt bleiben, lässt sich Fehlnutzung oder Sabotage vermeiden. Der Abruf von Lebenszyklusinformationen des Schaltschranks sollte nach Maßgabe eines Nutzerprofils und einer korrespondierenden Zugriffsverwaltung geregelt werden, damit jeder Nutzergruppe nur die diese interessierenden Informationen zur Verfügung gestellt werden. Beispielsweise kann das Nutzerprofil des Herstellers alle verfügbaren Informationen über die Schaltschrankausstattung enthalten, der Nutzer des Schaltschranks kann durch ein maßgeschneidertes Nutzerprofil im Zugriff auf die relevanten Betriebsdaten beschränkt werden, während ein Programmierer von speicherprogrammierbaren Steuerungen beispielsweise nur auf Informationen derartiger Einbaumodule Zugriff erhält.

Weiterhin wird vorgeschlagen, dass auch jedes Einbaumodul zur eindeutigen Identifizierung mit einer individuellen Kennung versehen ist, welche beispielsweise aus dessen Seriennummer abgeleitet werden kann. Diese individuelle Kennung kann beispielsweise am Einbaumodul als QR-Code oder dergleichen angebracht werden. Des Weiteren ist es auch möglich, die Kennung von Einbaumodulen auf einem RFID-Chip im Einbaumodul zu integrieren. Durch die eindeutige Kennung der Einbaumodule lässt sich über das dezentrale Nutzerterminal ein gezielter Zugriff auf die hierzu hinterlegten Dokumentationsinformationen vornehmen. Insoweit kann das dezentrale Nutzerterminal einen QR-Code-Scanner mit umfassen. Das Nutzerterminal ist vorzugweise als mobiler Rechner mit Display und Eingabetastatur ausgebildet. Über gängige Datenkommunikationskanäle, beispielsweise per Mobilfunk, kann eine Datenverbindung zu dem zentralen Server mit der hieran angeschlossenen Archivdatenbank hergestellt werden.

Vorteilhafterweise sollte der in der Archivdatenbank enthaltenen Test- und Abnahmeinformation C, der Inbetriebnahmeinformation D, der Wartungsinformation E und/oder Reparaturinformation F eine Bilddokumentationsdatei beigefügt werden. Diese Bilddokumentationsdatei kann beispielsweise aus einem Foto des Schaltschranklayouts zum jeweiligen Ereigniszeitpunkt bestehen, welches zu Dokumentationszwecken der im Datensatz der Archivdatenbank hinzugefügt wird. In diesem Sinne kann auch jede Änderung des Schaltschranklayouts nach einer Reparatur oder Wartung zusätzlich bildtechnisch dokumentiert werden. Hierdurch lassen sich zu einem späteren Zeitpunkt in der Schaltschrankausstattung vorgenommene Änderungen anschaulicher nachvollziehen. Weiterhin kann auch die sogenannte 'as built' Dokumentation dazugehören.
Diese umfasst zumindest den Schaltplan sowie eine Dokumentation der 3D-Montageaufbauplanung. Diese Dokumentation kann die Grundlage bilden, gegen welche die sach- und fachgerechte Umsetzung des physikalischen Schaltschranks geprüft wird.

Vorzugsweise ist die zumindest die Informationen A bis D enthaltene Dokumentation in der zentralen Archivdatenbank abgespeichert. Darüber hinaus könnte diese im Sinne einer Sicherungskopie auch auf einen im Schaltschrank abgeschirmt hinterlegten Datenträger gespeichert werden. Bei Verwendung einer solchen Sicherungskopie wird vorgeschlagen, dass eine Abspeicherung von Änderungen in der zentralen Archivdatenbank vorzugsweise mit einem Update der Sicherungskopie verbunden wird, welche vom zentralen Server nach Maßgabe eines Änderungsassistenzsystems erzwungen werden sollte, um eine konsistente multilokale elektronische Dokumentation zu gewährleisten.

Weitere die Erfindung verbessernde Maßnahmen werden nachstehend gemeinsam mit der Beschreibung eines bevorzugten Ausführungsbeispiels der Erfindung anhand der Figuren näher dargestellt. Es zeigt:
- Fig. 1: eine schematische Blockschaltbilddarstellung eines Systems zur Erfassung und Aufbereitung von Lebenszyklusinformationen über einen Schaltschrank einer industriellen Anlage, und
- Fig. 2: einen schematischen Ablaufplan eines Verfahrens zur Erfassung und Aufbereitung von Lebenszyklusinformationen, das in dem System gemäß Fig. 1 durchgeführt wird.

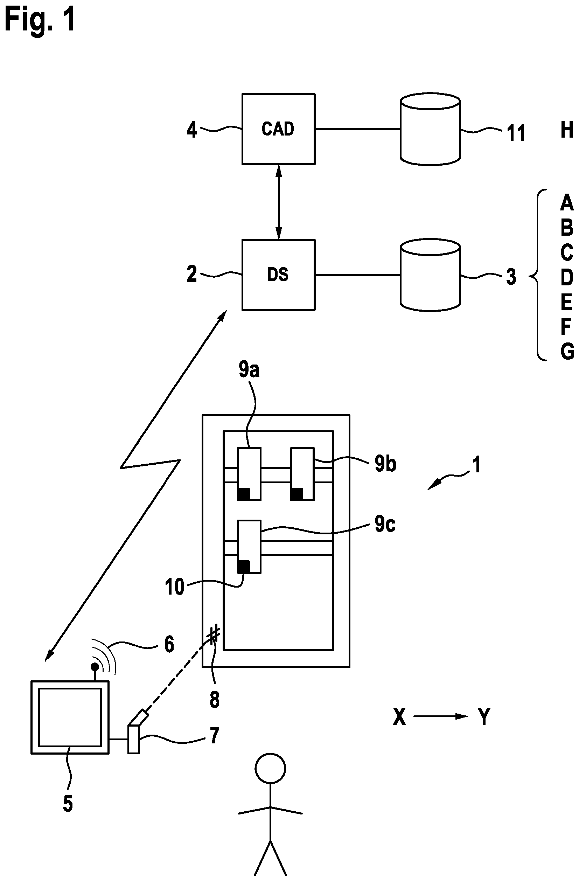

Gemäß Fig. 1 umfasst ein System zur Erfassung und Aufbereitung von Lebenszyklusinformationen über einen Schaltschrank 1 einer - hier nicht weiter dargestellten - industriellen Anlage, im Wesentlichen einen Dokumentationsserver 2, der an zentraler Stelle ortsfern vom Schaltschrank 1 platziert ist und die Lebenszyklusinformationen einer Vielzahl von Schaltschränken erfasst und aufbereitet. Diese Lebenszyklusinformationen werden in aufbereiteter Form in einer dem Dokumentationsserver 2 zugeordneten Archivdatenbank 3 abrufbar gespeichert.

Der Dokumentationsserver 2 extrahiert ausgehend von einer geplanten Konstruktion 4 des Schaltschranks 1, welche in der Planungsphase des Schaltschranks 1 erstellt wurde, Datenblattinformationen A der im Schaltschrank 1 verbauten einzelnen Einbaumodule 9a bis 9c. Dabei kann es sich beispielsweise um speicherprogrammierbare Steuerungen, Eingangs-/Ausgangsmodule, elektrische Klemmleisten oder dergleichen handeln. Der Dokumentationsserver 2 verknüpft diese Datenblattinformationen A jeweils mit Funktionsinformationen B, um diese unter einer individuellen Schaltschrankkennung 8 in Datensätzen in der Archivdatenbank 3 zu hinterlegen. Die Funktionsinformationen B beinhalten Angaben hinsichtlich der Zweckbestimmung jedes Einbaumoduls 9a bis 9c, welche beispielsweise enthalten kann, dass eine bestimmte speicherprogrammierbare Steuerung Betriebszyklen einer Pumpe steuert.

Am Ort X, an welchem sich der Schaltschrank 1 befindet, verfügt ein Installateur über ein dezentrales Nutzerterminal 5, welches hier als Laptop mit Datenübertragungsschnittstelle ausgebildet ist. Über die Datenübertragungsschnittstelle, beispielsweise Mobilfunk, ist der Installateur in der Lage, Informationen über den Schaltschrank 1 vom Dokumentationsserver 2 abzurufen und weitere Daten unter der individuellen Schaltschrankkennung 8 des Schaltschranks 1 in der Archivdatenbank 3 abzuspeichern, um hierdurch eine Art elektronischer Schaltschrankmappe aufzubauen.

So führt der Installateur vor der Inbetriebnahme des Schaltschranks 1 erforderliche Test- und Abnahmemaßnahmen am Schaltschrank 1 durch und fügt die hieraus resultierenden Test- und Abnahmeinformationen C des Schaltschranks 1 der Archivdatenbank 3 hinzu. Zur Überprüfung, welche Test- und Abnahmemaßnahmen erforderlich sind, greift der Installateur zuvor auf die Datenblattinformationen A der einzelnen Einbaumodule 4a bis 4c zu. Hierin kann beispielsweise vermerkt sein, mit welcher Prüfspannung ein vorgeschriebener Test durchzuführen ist. Der Dokumentationsserver 2 unterstützt den Installateur im Rahmen der die Inbetriebnahme vorbereitenden Arbeiten, indem die notwendigen Test- und Abnahmeinformationen C lückenlos erfasst werden und der Dokumentationsserver 2 erst dann über dem dezentralen Nutzerterminal 5 eine Inbetriebnahmefreigabe für den Schaltschrank 1 auslöst, wenn alle notwendigen Test- und Abnahmeinformationen C in der Archivdatenbank 3 erfasst sind. Dabei kann vorgesehen werden, dass eine erste Inbetriebnahme des Schaltschranks 1 nur über das dezentrale Nutzerterminal 5 ausgelöst werden kann, indem beispielsweise eine initiale Einschaltsteueranweisung an den Schaltschrank 1 ausgegeben wird. Hierzu kann das dezentrale Nutzerterminal 5 über eine NFC-Kommunikationsschnittstelle für den Schaltschrank 1 verfügen. Ferner ist der dezentrale Nutzerterminal 5 dieses Ausführungsbeispiels mit einem QR-Code-Scanner 7 ausgestattet, mit welchem ein am Schaltschrank 1 angebrachter QR-Code als eindeutige Schaltschrankkennung einlesbar ist. Nach Einlesen der individuellen Schaltschrankkennung 8 des Schaltschranks 1 kann über den dezentralen Nutzerterminal 5 in Fernzugriff auf den Dokumentationsserver 2 dort aufbereitete Lebenszyklusinformationen des Schaltschranks 1 abgerufen werden und in umgekehrter Richtung weitere Lebenszyklusinformationen zur Archivdatenbank 3 hinzugefügt werden. Neben dem Einlesen der Schaltschrankkennung 8 kann der QR-Code-Scanner 7 bei diesem Ausführungsbeispiel auch für ein Einlesen von ebenfalls als QR-Code ausgebildeten individuellen Kennungen der einzelnen Einbaumodule 9a bis 9c herangezogen werden, um eine Identifizierung im Rahmen der Schaltschrankausstattung zu erleichtern sowie einen automatischen Durchgriff auf spezifische Datenblattinformationen A für jedes Einbaumodul 9a bis 9c zu ermöglichen.

Zusätzlich beinhalten die Datensätze der Archivdatenbank 3 einen Verweis auf die dem Schaltschrank 1 zugrunde liegende dreidimensionale geplanten Konstruktion 4, so dass vom dezentralen Nutzerterminal 5 darüber hinaus auch auf in einer CAD-Datenbank 11 hinterlegte Konstruktionsinformationen H für die Schaltschrankausstattung durchgegriffen werden kann.

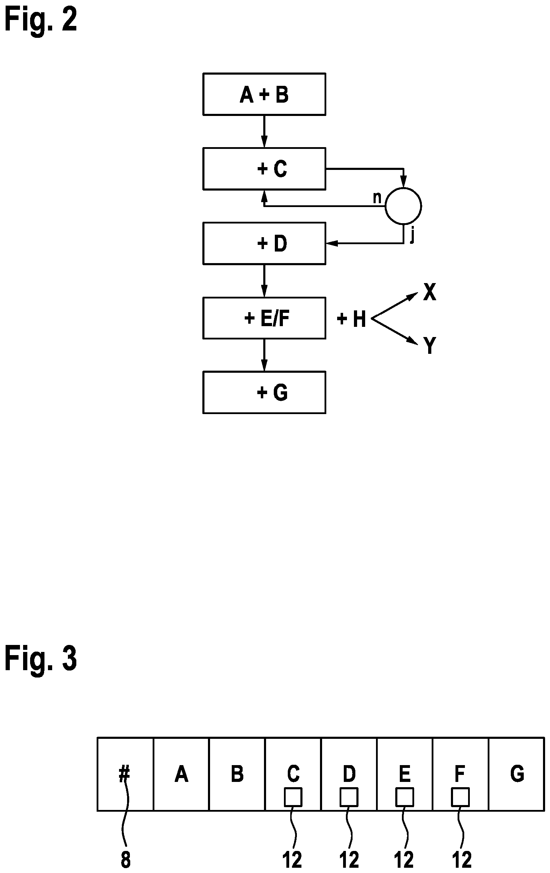

Die Fig. 2 illustriert einzelne Verfahrensschritte zur Erfassung und Aufbereitung von Lebenszyklusinformationen über den Schaltschrank 1, welche zu verschiedenen Zeitpunkten oder Zeitphasen des Lebenszyklus des Schaltschranks 1 erfasst und aufbereitet werden, um eine vollständige dynamische Dokumentation hierüber zu erschaffen.

Zum Zeitpunkt I der Erstellung des Schaltschranks wird ausgehend von der geplanten Konstruktion die Datenblattinformation A verbauter Einbaumodule mit Funktionsinformationen B über deren Anwendung im Rahmen der industriellen Anlage verknüpft. Hieraus wird unter der individuellen Schaltschrankkennung eine Datensatzstruktur in einer Archivdatenbank angelegt.

Zum Zeitpunkt II einer technischen Abnahme des Schaltschranks werden Test- und Abnahmeinformationen C des Schaltschranks hinzugefügt. Über eine Testschleife wird geprüft, ob alle notwendigen Test- und Abnahmeinformationen C für den Schaltschrank vorliegen. Solange diese notwendigen Informationen nicht vorliegen, wartet das System auf die Vervollständigung der Test- und Abnahmeinformationen C. Liegen die notwendigen Test- und Abnahmeinformationen C für die Schaltschrankausstattung vor, so wird eine Inbetriebnahmefreigabe für den Schaltschrank ausgelöst, welche in ein Einschaltsignal resultiert.

Zum Zeitpunkt III wird die Inbetriebnahme des Schaltschranks durchgeführt, wobei den Datensätzen der Archivdatenbank ergänzende Inbetriebnahmeinformationen D des Schaltschranks hinzugefügt werden. Diese Inbetriebnahmeinformationen D können beispielsweise Datum und Uhrzeit der Inbetriebnahme sowie Name des die Inbetriebnahme durchführenden Installateurs zu Dokumentationszwecken beinhalten.

Der Zeitpunkt IV kennzeichnet Wartungs- oder Reparaturereignisse, welche den normalen Betrieb des Schaltschranks einschränken oder unterbrechen. Eine Wartung kann beispielsweise einen Austausch geeichter Messinstrumente, beispielsweise Stromzähler, beinhalten und eine dahingehende Wartungsinformation E wird der Archivdatenbank hinzugefügt. In analoger Weise wird eine Reparaturmaßnahme eines defekten Einbaumoduls durch eine diesbezügliche Reparaturinformation F erfasst und der Archivdatenbank hinzugefügt. Diese Reparaturinformation F kann beispielsweise die Kennung eines ausgetauschten Einbaumoduls umfassen, welche durch die neue Kennung des Austauschgerätes ersetzt wird. Außerdem werden der Zeitpunkt der Reparatur und der hierfür verantwortliche Installateur protokolliert.

Dabei unterstützt die dynamische Dokumentation der Lebenszyklusinformationen des Schaltschranks einen Reparaturvorgang dahingehend, dass durch Rückgriff auf Datenblattinformationen A oder Konstruktionsinformationen H eine Entscheidung darüber getroffen werden kann, ob eine Reparatur vor Ort X oder in einer ortsfernen Werkstatt Y zu erfolgen hat.

In analoger Weise werden Zeitpunkte V im Lebenszyklus des Schaltschranks erfasst, in welchen Störungen des Betriebs des Schaltschranks auftreten, beispielsweise Stromausfälle, die der Archivdatenbank 3 als Störungsinformationen G hinzugefügt werden. Eine Zwischenspeicherung dieser Informationen erfolgt vorübergehend in einem Zwischenspeicher des Schaltschranks und beim nächsten Auslesen des Zwischenspeichers durch ein Nutzerterminal kann eine Übertragung an die Archivdatenbank erfolgen.

In Fig. 3 ist die Struktur eines spezielle Lebenszyklusinformationen eines Schaltschrankes beinhaltenden Datenformats angegeben, dessen Schlüsselkennung die eindeutige Kennung 8 des Schaltschranks darstellt. Diese Schlüsselkennung kann beispielsweise durch einen Zahlencode umgesetzt werden. Dem Datensatz wird eine Kennung jedes in dem Schaltschrank verbauten Einbaumoduls mit zugeordneter Datenblattinformation A hinzugefügt und mit Funktionsinformationen B über die verbauten Einbaumodule verknüpft. Weiterhin werden die aus der Testphase eines hergestellten Schaltschranks resultierenden Test- und Abnahmeinformationen C der Schaltschrankausstattung sowie anschließende Inbetriebnahmeinformationen D über den Schaltschrank dem Datensatz hinzugefügt. Im späteren Lebenszyklus generierte Wartungsinformationen E, Reparaturinformationen F sowie Störungsinformationen G komplettieren das Datenformat der dynamischen Dokumentation über den Lebenszyklus des Schaltschranks. Insbesondere die Test- und Abnahmeinformationen C, die Inbetriebnahmeinformationen D und Wartungs- und Reparaturinformationen E/F können mit Bilddokumentationsdateien 12 ergänzt werden, welche beispielsweise ein zu diesen Zeitpunkten erstelltes Layoutfoto der Schaltschrankausstattung beinhalten.

### Bezugszeichenliste

- 1: Schaltschrank
- 2: Dokumentationsserver
- 3: Archivdatenbank
- 4: geplanten Konstruktion
- 5: dezentrales Nutzerterminal
- 6: NFC-Schnittstelle
- 7: QR-Code-Scanner
- 8: Schaltschrankkennung
- 9: Einbaumodul
- 10: Kennung (des Einbaumoduls)
- 11: CAD-Datenbank
- 12: Bilddokumentationsdatei
- A: Datenblattinformation
- B: Funktionsinformation
- C: Test- und Abnahmeinformation
- D: Inbetriebnahmeinformation
- E: Wartungsinformation
- F: Reparaturinformation
- G: Störungsinformation
- X: vor Ort
- Y: in Werkstatt

## Patentansprüche

1. Computergestütztes Verfahren zur Erfassung und Aufbereitung von Lebenszyklusinformationen über einen Schaltschrank (1) einer industriellen Anlage, bei welchem:
- bei der Erstellung des Schaltschranks (1) ausgehend von der geplanten Konstruktion (4) zumindest Datenblattinformationen (A) der verbauten Einbaumodule (9a - 9c) mit Funktionsinformationen (B) über deren Anwendung in der industriellen Anlage verknüpft werden, um diese in einer zentralen Archivdatenbank (3) unter einer individuellen Schaltschrankkennung (8) in Datensätzen zu hinterlegen, wobei
- bei einer technischen Abnahme des Schaltschranks (1) zu den Datensätzen Test- und Abnahmeinformationen (C) des Schaltschranks (1) unter Berücksichtigung zumindest der Datenblattinformationen (A) hinzugefügt werden,
- bei der Inbetriebnahme des Schaltschranks (1) den Datensätzen der Archivdatenbank (3) ergänzende Inbetriebnahmeinformationen (D) des Schaltschranks (1) über ein dezentral bedienbares Nutzerterminal (5) hinzugefügt werden,
**dadurch gekennzeichnet, dass** das Auslösen der Inbetriebnahmefreigabe für den Schaltschrank (1) durch einen auf die Archivdatenbank (3) zugreifenden Dokumentationsserver (2) über das dezentrale Nutzerterminal (5) dann durchgeführt wird, wenn alle, zur Vollständigkeit der hierfür durch den Benutzer zuvor erfassten notwendigen Test- und Abnahmeinformationen (C), welche sich aus den abgespeicherten Datenblattinformationen (A) der verbauten Einbaumodule (9a - 9c) ergeben, in der Archivdatenbank (3) hinzugefügt wurden.

2. Computergestütztes Verfahren nach Anspruch 1, **dadurch gekennzeichnet,**
**dass** bei Wartungen oder Reparaturen nach Inbetriebnahme des Schaltschranks (1) Wartungsinformationen (E) beziehungsweise Reparaturinformationen (F) des Schaltschranks (1) der Archivdatenbank (3) durch den Benutzer über das dezentral bedienbare Nutzerterminal (5) hinzugefügt werden, um die Informationen über die aktuelle Schaltschrankausstattung zu aktualisieren.

3. Computergestütztes Verfahren nach Anspruch 1, **dadurch gekennzeichnet,**
**dass** bei auftretender Störungen des Betriebs des Schaltschranks (1) Störungsinformationen (G) des Schaltschranks (1) der Archivdatenbank (3) automatisch oder durch den Benutzer über das dezentral bedienbare Nutzerterminal (5) hinzugefügt werden.

4. Computergestütztes Verfahren nach einem der vorstehenden Ansprüche, **dadurch gekennzeichnet,**
**dass** über das dezentral bedienbare Nutzerterminal (5) die aktuellen Lebenszyklusinformationen des Schaltschranks (1) nach autorisierter Eingabe der Schaltschrankkennung (8) zur Visualisierung und Anpassung der in der Archivdatenbank (3) hinterlegten Informationen (A bis G) abgerufen werden, wobei die Historie vormals eingegebener Informationen in der Archivdatenbank (3) unveränderbar hinterlegt bleiben.

5. Computergestütztes Verfahren nach Anspruch 4, **dadurch gekennzeichnet,**
**dass** der Abruf von Lebenszyklusinformationen des Schaltschranks (1) nach Maßgabe eines Nutzerprofils gefiltert wird.

6. System zur Erfassung und Aufbereitung von Lebenszyklusinformationen über einen Schaltschrank (1) einer industriellen Anlage, mit einem Dokumentationsserver (2) zum Verknüpfen von Datenblattinformationen (A) der ausgehend von der geplanten Konstruktion (4) im Schaltschrank (1) verbauten Einbaumodule (9a - 9c) mit Funktionsinformationen (B) über deren Anwendung im Rahmen der Schaltschrankausstattung, um diese in einer zentralen Archivdatenbank (3) unter einer individuellen Schaltschrankkennung (8) in Datensätzen zu hinterlegen, wobei der Benutzer über ein dezentrales Nutzerterminal (5) via Dokumentationsserver (2) zu den Datensätzen der zentralen Archivdatenbank (3) Test- und Abnahmeinformationen (C) des Schaltschranks (1) unter Berücksichtigung zumindest der Datenblattinformationen (A) hinzufügt, wobei der Benutzer bei der Inbetriebnahme des Schaltschranks (1) über das dezentrale Nutzerterminal (5) zusätzliche Inbetriebnahmeinformationen (D) über den Schaltschrank (1) den Datensätzen der Archivdatenbank (3) abrufbar hinzufügt, **dadurch gekennzeichnet, dass** das System dazu ausgebildet ist, die Inbetriebnahme des Schaltschranks (1) durch einen auf die Archivdatenbank (3) zugreifenden Dokumentationsserver (2) über das dezentrale Nutzerterminal (5) auszulösen, und zwar auf Basis aller, zur Vollständigkeit hierfür durch den Benutzer zuvor erfassten notwendigen Test- und Abnahmeinformationen (C), welche sich aus den abgespeicherten Datenblattinformationen (A) der verbauten Einbaumodule (9a - 9c) ergeben, die der Archivdatenbank (3) hinzugefügt wurden.

7. System nach Anspruch 6, **dadurch gekennzeichnet,**
**dass** jedes Einbaumodul (9a - 9c) zur eineindeutigen Identifikation mit einer individuellen, eineindeutigen Kennung (10) versehen ist, welche auslesbar im oder am Einbaumodul (9a - 9c) angeordnet ist.

8. System nach Anspruch 6, **dadurch gekennzeichnet,**
**dass** Datensätze der Archivdatenbank (3) einen Verweis auf die dem Schaltschrank (1) zu Grunde liegende dreidimensionale geplante Konstruktion (4) umfassen, um hierüber auf in einer CAD-Datenbank (11) hinterlegte Konstruktionsinformationen (H) durchzugreifen.

9. System nach Anspruch 6, **dadurch gekennzeichnet,**
**dass** der in der Archivdatenbank (3) enthaltenen Test- und Abnahmeinformation (C) und/oder der Inbetriebnahmeinformation (D) eine Bilddokumentationsdatei (12) beigefügt ist.

10. Datenträger, in einem Schaltschrank (1) befindlich, der eine Sicherungskopie zumindest eines Teils der nach dem computergestützten Verfahren nach einem der Ansprüche 1 bis 5 gewonnenen Informationen (A bis G), zumindest jedoch die Informationen (A bis D) des Anspruchs 1 enthält.

11. Computerprogrammprodukt mit Programmcodemitteln zur Durchführung der computergestützten Schritte des Verfahrens nach einem der Ansprüche 1 bis 5, wenn das Computerprogrammprodukt auf einem der Archivdatenbank (3) zugeordneten zentralen Dokumentationsserver (2) eines Systems nach einem der Ansprüche 6 bis 9 abläuft.

## Claims

1. A computer-aided method for the acquisition and processing of life cycle information about a switch cabinet (1) of an industrial plant, in which:
during the construction of the switch cabinet (1), starting from the planned design (4), at least data sheet information (A) of the installed built-in modules (9a - 9c) is linked with function information (B) about their use in the industrial plant, in order to store them in data records in a central archive database (3) under an individual switch cabinet identification (8), wherein
- in the case of a technical acceptance of the switch cabinet (1), test and acceptance information (C) of the switch cabinet (1) is added to the data sets, taking into account at least the data sheet information (A),
- during commissioning of the switch cabinet (1), supplementary commissioning information (D) of the switch cabinet (1) is added to the data records of the archive database (3) via a decentrally operated user terminal (5)
**characterized in that** the activation of the commissioning release for the switch cabinet (1) by a documentation server (2) accessing the archive database (3) via the decentralized user terminal (5) is carried out if all necessary test and acceptance information (C) acquired by the user beforehand for sake of completeness, and which results from the stored data sheet information (A) of the built-in modules (9a - 9c), was added to the archive database (3).

2. The computer-assisted method according to claim 1, **characterized in that** in the case of maintenance or repairs after the switch cabinet (1) has been put into operation, maintenance information (E) or repair information (F) of the switch cabinet (1) is added to the archive database (3) by the user via the decentrally operable user terminal (5) in order to update the information on the current switch cabinet equipment.

3. The computer-aided method according to claim 1, **characterized in that,** in the case of malfunctions occurring in the operation of the switch cabinet (1), malfunction information (G) of the switch cabinet (1) is added to the archive database (3) automatically or by the user via the user terminal (5) which can be operated decentrally.

4. The computer-aided method according to one of the above claims, **characterized in that** the current life cycle information of the switch cabinet (1) is called up via the decentrally operated user terminal (5) after authorized input of the switch cabinet identification (8) for visualization and adaptation of the information (A to G) stored in the archive database (3), the history of previously input information remaining unalterably stored in the archive database (3).

5. The computer-aided method according to claim 4, **characterized in that** the retrieval of life cycle information of the switch cabinet (1) is filtered according to a user profile.

6. A system for recording and processing life cycle information about a switch cabinet (1) of an industrial plant, having a documentation server (2) for linking data sheet information (A) of the built-in modules (9a - 9c) installed in the switch cabinet (1) on the basis of the planned construction (4) with function information (B) about their use in the context of the switch cabinet equipment, in order to store them in a central archive database (3) in data records under an individual switch cabinet identification (8), wherein the user adds test and acceptance information (C) of the switch cabinet (1) to the data records of the central archive database (3) via a decentralized user terminal (5) via a documentation server (2), taking into account at least the data sheet information (A), wherein the user adds additional commissioning information (D) about the switch cabinet (1) to the data records of the archive database (3) in a retrievable manner via the decentralized user terminal (5) when the switch cabinet (1) is put into operation, **characterized in that** the system is designed to initiate the commissioning of the switch cabinet (1) by a documentation server (2) accessing the archive database (3) via the decentralized user terminal (5), and namely on the basis of all the necessary test and acceptance information (C) previously recorded by the user for this purpose for sake of completeness, which results from the stored data sheet information (A) of the installed built-in modules (9a - 9c) which have been added to the archive database (3).

7. The system according to claim 6, **characterized in that** each built-in module (9a-9c) is provided with an individual, unambiguous identification (10) for unambiguous identification, which is arranged in or on the built-in module (9a-9c) so as to be readable.

8. The system according to claim 6, **characterized in that** data records of the archive database (3) comprise a reference to the three-dimensional planned construction (4) on which the switch cabinet (1) is based in order to access construction information (H) stored in a CAD database (11).

9. The system according to claim 6, **characterized in that** an image documentation file (12) is attached to the test and acceptance information (C) and/or the commissioning information (D) contained in the archive database (3).

10. A data carrier, located in a switch cabinet (1), which contains a backup copy of at least part of the information (A to G) obtained by the computer-aided method according to one of claims 1 to 5, but at least the information (A to D) of claim 1.

11. A computer program product with program code means for Implementation of the computer-aided steps of the method according to one of claims 1 to 5, if the computer program product runs on a central documentation server (2) of a system according to any one of claims 6 to 9, which is assigned to the archive database (3).

## Revendications

1. Procédé assisté par ordinateur de collecte et de traitement d'informations de cycle de vie relatives à une armoire de commande (1) d'une installation industrielle, dans lequel :
- lors de la construction de l'armoire de commande (1) à partir de la construction prévue (4), au moins des informations d'une feuille de données (A) relatives aux modules intégrés installés (9a - 9c) sont reliés à des informations fonctionnelles (B) sur leur utilisation dans l'installation industrielle, afin de les consigner en blocs de données dans une base de données d'archivage centrale (3) sous un identifiant individuel d'armoire de commande (8),
- lors d'un contrôle technique de l'armoire de commande (1), des informations de test et de contrôle (C) de l'armoire de commande (1) sont ajoutées aux blocs de données en tenant compte au moins des informations de la feuille de données (A),
- lors de la mise en service de l'armoire de commande (1), des informations complémentaires de démarrage (D) de l'armoire de commande (1) sont ajoutées aux blocs de données de la base de données d'archivage (3) via un terminal utilisateur (5) utilisable de manière décentralisée,
**caractérisé en ce que** le déclenchement de la validation de la mise en service de l'armoire de commande (1) est ensuite effectué par un serveur de documentation (2) accédant à la base de données d'archivage (3) via le terminal utilisateur décentralisé (5) lorsque toutes les informations de test et de contrôle (C) nécessaires préalablement saisies par l'utilisateur, lesquelles résultent des informations de la feuille de données (A) stockées relatives aux modules intégrés installés (9a - 9c), ont été ajoutées dans la base de données d'archivage (3).

2. Procédé assisté par ordinateur selon la revendication 1, **caractérisé en ce qu'**en cas d'entretien ou de réparation après la mise en service de l'armoire de commande (1), des informations d'entretien (E), respectivement des informations de réparation (F), de l'armoire de commande (1) sont ajoutées à la base de données d'archivage (3) par l'utilisateur via le terminal utilisateur (5) utilisable de manière décentralisée, afin de mettre à jour les informations relatives à l'équipement actuel de l'armoire de commande.

3. Procédé assisté par ordinateur selon la revendication 1, **caractérisé en ce que** lorsque des perturbations du fonctionnement de l'armoire de commande (1) surviennent, des informations relatives aux perturbations (G) de l'armoire de commande (1) sont ajoutées à la base de données d'archivage (3), soit automatiquement, soit par l'utilisateur via le terminal utilisateur (5) utilisable de manière décentralisée.

4. Procédé assisté par ordinateur selon l'une des revendications précédentes, **caractérisé en ce que** les informations actuelles de cycle de vie de l'armoire de commande (1) sont récupérées via le terminal utilisateur (5) utilisable de manière décentralisée, après la saisie autorisée de l'identifiant d'armoire de commande (8) pour visualiser et adapter les informations stockées (A à G) dans la base de données d'archivage (3), l'historique des informations précédemment saisies étant consigné de façon non modifiable dans la base de données d'archivage (3).

5. Procédé assisté par ordinateur selon la revendication 4, **caractérisé en ce que** la récupération des informations de cycle de vie de l'armoire de commande (1) est filtrée selon un profil d'utilisateur.

6. Système de collecte et de traitement d'informations de cycle de vie relatives à une armoire de commande (1) d'une installation industrielle, doté d'un serveur de documentation (2) pour relier des informations d'une feuille de données (A), relatives aux modules intégrés installés (9a - 9c) dans l'armoire de commande (1) à partir de la construction prévue (4), avec des informations fonctionnelles (B) sur leur utilisation dans le cadre de l'équipement de l'armoire de commande, afin de les stocker en blocs de données dans une base de données d'archivage centrale (3) sous un identifiant individuel d'armoire de commande (8), l'utilisateur ajoutant des informations de test et de contrôle (C) de l'armoire de commande (1) aux blocs de données de la base de données d'archivage centrale (3) via un terminal utilisateur décentralisé (5) via le serveur de documentation (2), en prenant en considération au moins les informations de la feuille de données (A), l'utilisateur ajoutant de manière récupérable des informations complémentaires de mise en service (D) relatives à l'armoire de commande (1) aux blocs de données de la base de données d'archivage (3) lors de la mise en service de l'armoire de commande (1) via le terminal utilisateur décentralisé (5), **caractérisé en ce que** le système est conformé pour déclencher la mise en service de l'armoire de commande (1) par un serveur de documentation (2) accédant à la base de données d'archivage (3) via le terminal utilisateur décentralisé (5), sur la base de toutes les informations de test et de contrôle (C) nécessaires préalablement saisies par l'utilisateur, lesquelles résultent des informations de la feuille de données (A) stockées relatives aux modules intégrés installés (9a - 9c) qui ont été ajoutés à la base de données d'archivage (3).

7. Système selon la revendication 6, **caractérisé en ce que** chaque module intégré (9a - 9c) est prévu avec un identifiant individuel unique (10) pour une identification unique qui peut être lu dans ou sur le module intégré (9a - 9c).

8. Système selon la revendication 6, **caractérisé en ce que** les blocs de données de la base de données d'archivage (3) contiennent une référence à la construction prévue (4) tridimensionnelle sous-jacente de l'armoire de commande (1), afin d'accéder aux informations de construction (H) stockées dans une base de données CAO (11).

9. Système selon la revendication 6, **caractérisé en ce qu'**un fichier de documentation image (12) est ajouté aux informations de test et de contrôle (C) contenues dans la base de données d'archivage (3) et / ou aux informations de mise en service (D).

10. Support de données situé dans une armoire de commande (1), lequel contient une copie de sauvegarde d'au moins une partie des informations (A à G) récupérées par le procédé assisté par ordinateur selon l'une des revendications 1 à 5, contenant cependant au moins les informations (A à D) de la revendication 1.

11. Produit programme d'ordinateur doté de moyens de code de programme pour la mise en oeuvre des étapes assistées par ordinateur du procédé selon l'une des revendications 1 à 5, lorsque le produit programme d'ordinateur est exécuté sur un serveur central de documentation (2), associé à la base de données d'archivage (3), d'un système selon l'une des revendications 6 à 9.
